# EUROPÄISCHE PATENTSCHRIFT

(11) **EP 0 849 769 B1**
(45) Veröffentlichungstag und Bekanntmachung des Hinweises auf die Patenterteilung: **02.05.2003**
(21) Anmeldenummer: 97121925.8
(22) Anmeldetag: 12.12.1997
(51) Int. Cl.: H01K 3/00, H01J 9/20, H01J 37/32

(54) **Verfahren und Vorrichtung zur Aussenbeschichtung von Lampen**
Process and device for externally coating lamps
Procédé et dispositif pour le revêtement externe de lampes

(30) Priorität: 17.12.1996 DE 19652454
(43) Veröffentlichungstag der Anmeldung: 24.06.1998
(73) Patentinhaber: Schott Glas, 55122 Mainz (DE); CARL-ZEISS-STIFTUNG trading as Schott Glas, 55122 Mainz (DE)
(72) Erfinder: Hack, Hrabanus, Dr., 55126 Mainz (DE); Holdmann, Torsten, 55597 Wöllstein (DE); Paquet, Volker, 55126 Mainz (DE); Segner, Johannes, Dr., 55442 Stromberg (DE)
(74) Vertreter: Fuchs Mehler Weiss & Fritzsche

(56) Entgegenhaltungen:
- EP-A- 0 369 254
- DE-A- 3 045 025
- DE-A- 3 632 748
- FR-A- 2 622 898
- US-A- 3 484 276
- PATENT ABSTRACTS OF JAPAN vol. 016, no. 392 (E-1251), 20. August 1992 & JP 04 129159 A (YASUO TARUI;OTHERS: 01), 30. April 1992
- M. WALTHER, M. HEMING, M. SPALLEK: "Multilayer barrier coating system produced by plasma-impulse chemical vapor deposition (PICVD)" SURFACE & COATINGS TECHNOLOGY,1996, Seiten 200-202, XP002099295

## Beschreibung

Die Erfindung betrifft ein Verfahren zur Außenbeschichtung von Lampen. Die Erfindung bezieht sich auch auf eine Vorrichtung zur Außenbeschichtung gemäß dem Oberbegriff des Patentanspruchs 12.

Die Außenbeschichtung von Glaskörpern ist insbesondere bei Glühlampen von Interesse, weil sich dadurch das Spektrum der von der Lampe emittierten Strahlung beeinflussen läßt, um beispielsweise eine bestimmte Farbwirkung zu erzielen oder um den Energiebedarf der Lampe zu vermindern.

Glühlampen strahlen einen großen Teil der zugeführten Energie in Form von Wärmestrahlung und nicht als sichtbare Strahlung ab. Um die unerwünschte Wärmestrahlung nutzbringend zu verwenden, ist es bekannt, durch eine auf der Außenfläche der Lampe aufgebrachte infrarotreflektierende Beschichtung die Wärmestrahlung auf die Leuchtwendel zurückzustrahlen und so den Energiebedarf für die Aufrechterhaltung ihrer Betriebstemperatur zu verringern. Dies wird beispielsweise in "IEE Proceedings-A", Vol. 140, No. 6, Nov. 1993, S. 418 beschrieben.

Bei unbeschichteten Halogenlampen beträgt der Anteil der Wärmestrahlung mindestens 80%. Wenn die Halogenlampen mit einer entsprechenden Beschichtung versehen werden, läßt sich der Energiebedarf theoretisch auf etwa 32% des Energiebedarfs einer unbeschichteten Lampe vermindern. Nach dem derzeitigen Stand der Technik liegt der Anteil der Wärmestrahlung immer noch bei 70%. Es besteht daher ein großes Interesse daran, die Beschichtung von Glühlampen weiter zu entwickeln.

Die Beschichtung besteht im allgemeinen aus einem Vielschicht-Interferenzsystem aus hoch- und tiefbrechenden Schichten, vorzugsweise aus tiefbrechenden SiO₂- und hochbrechenden TiO₂- oder Ta₂O₅-Schichten.

Die Schichten werden nach unterschiedlichen Verfahren auf die Glühlampe aufgebracht. Aus der EP 0 305 135 ist ein aufwendiges Tauchverfahren bekannt und in der EP 0 369 253 wird ein CVD-Verfahren beschrieben. Bei dem PVD-Verfahren gemäß der EP 0 409 451 werden mittels Gleichspannungs-Kathodenzerstäubung Ta₂O₅- bzw. SiO₂-Schichten auf die Lampen aufgebracht, wobei nach dem, Aufbringen der dünnen Schicht aus Ta bzw. Si eine Oxidation durchgeführt wird. Diese Schritte werden nacheinander so lange durchgeführt, bis jede so entstandene Ta- bzw. Si-Oxidschicht die erforderliche Dicke erreicht hat.

Diese bekannten Verfahren haben den Nachteil einer langen, mehrere Stunden dauernden Prozeßzeit für die Herstellung des Schichtpaketes mit dem damit verbundenen zeitproportionalen Risiko des Ausfalls einer Anlagenkomponente. Mittels der Tauchbeschichtung und dem CVD-Verfahren können nur Schichten mit vergleichsweise niedrigen Brechzahlen aufgebracht werden, so daß die Gesamtzahl der Schichten des Pakets erhöht werden muß, um die erforderliche IR-Reflexion zu erhalten. Bei dem PVD-Verfahren gemäß der EP 0 409 451 ist der mechanische Aufwand sehr groß, so daß auch die Störanfälligkeit der Vorrichtung zunimmt.

Die DE 3632748 C2 beschreibt ein Verfahren zur Beschichtung, insbesondere zur Innenbeschichtung von Hohlkörpern mit polymeren Deckschichten durch Plasmapolymerisation. Die Hohlkörper werden in eine Mikrowellenkammer eingesetzt, in die von außen an mehreren Stellen Mikrowellen eingespeist werden, so daß in der Kammer ein homogenes elektrisches Feld herrscht. Über eine mikrowellenmäßig abgeschirmte Düse werden entweder das zur Beschichtung vorgesehene Monomer oder ein Gemisch von Monomeren und ein Plasmaträger in das Innere des Hohlkörpers eingeleitet, so daß ein Plasma gezündet und die Plasmapolymerisation durchgeführt werden kann. Die Außenbeschichtung von Metall aufweisenden Hohlkörpern wird in dieser Vorveröffentlichung ebensowenig erwähnt, wie in "Surface and Coatings Technology", 80 (1996), 200-202, wo ein PICVD-Verfahren zur Herstellung eines für die Anwendung als Diffusionssperre ausreichend uniformen Schichtsystems auf die Innenfläche von Kunststoffbehältern beschrieben wird. Obwohl Mikrowellen-Plasma-CVD-Verfahren grundsätzlich zur Beschichtung von Glaskörpern geeignet sind, wurden diese Verfahren bisher zur Außenbeschichtung von Glaskörpern, die metallische Bestandteile aufweisen, wie z.B. Glühlampen, nicht eingesetzt. Der Grund liegt möglicherweise darin, daß man befürchtet, daß die leitfähigen Bereiche wie Lampenwendel und Anschlußstifte die ursprüngliche Feldverteilung durch Reflexionen stören.

Ein weiterer Grund liegt vermutlich darin, daß die zu beschichtenden Lampen vorzugsweise Halogenlampen sind, deren Leistungsgrenze bei typischerweise 60 Watt liegt. Mikrowellen-CVD-Plasmen jedoch im Leistungsbereich von 100 Watt bis einigen Kilowatt betrieben werden. Wird die Leistung in die metallischen Bauteile der Lampe eingekoppelt, können diese z.B. durch Schmelzen zerstört werden.

Ein weiterer Grund ist darin zu sehen, daß im Inneren der Halogenlampen ein Plasma angeregt werden könnte. Mit Mikrowellen können in einem großen Druckbereich von 10⁻³ Pa bis zu Atmosphärendruck Plasmen erzeugt werden. Das Gas im Inneren der Halogenlampen liegt im Atmosphärendruckbereich vor und kann mit Mikrowellen im Gegensatz zu anderen Anregungsfrequenzen somit ebenfalls prinzipiell zu einem Br- oder I-haltigem Plasma angeregt werden, das die Lampenwendel zersetzt und die innere Oberfläche der Lampe verschmutzen kann.

Aufgabe der Erfindung ist daher ein Verfahren und eine Vorrichtung zur hochwertigen Beschichtung der äußeren Oberfläche von Lampen mit einer oder mehreren Schichten, das auf einfache Weise bei kurzer Prozeßdauer durchführbar ist.

Diese Aufgabe wird mit einem Verfahren gelöst, bei dem die Beschichtung in einem Mikrowellenreaktor mittels eines Mikrowellen-Plasma-CVD-Verfahrens durchgeführt wird, wobei die in den Mikrowellenreaktor eingekoppelte Mikrowellenleistung ≥ einem Schwellenwert gewählt wird, bei dem sich ein Plasma mit verminderter Durchlässigkeit für Mikrowellen-Strahlung einstellt.

Es hat sich überraschend herausgestellt, daß ein Mikrowellen-Plasma-CVD-Verfahren trotz der Bedenken der Fachwelt auch für die Beschichtung von metallaufweisenden Glaskörpern, wie Glühlampen, geeignet ist, wenn diese Kriterien eingehalten werden, was von der Gesamtkonfiguration der Mikrowellenanlage, Größe und Form der zu beschichtenden Lampe und auch von Eigenschaften des Beschichtungsgases abhängt.

Solche Plasmen mit verminderter Durchlässigkeit, die für Mikrowellen-Strahlung einer Frequenz von 1-3 GHz durch Elektronendichten > 10¹⁰ 1/cm³ gekennzeichnet sind, sind beispielsweise aus Gerd Janzen, Plasmatechnik: Grundlagen, Anwendungen, Diagnostik, Heidelberg, Hüthig, 1992, S. 294 ff. bekannt. Danach liegt ein derartiges Plasma dann vor, wenn die Mikrowellenfrequenz kleiner ist als die Plasmafrequenz, die wiederum von der Elektronendichte im Plasma abhängt.

Die Erfindung macht sich diese Eigenschaft des Plasmas zunutze, indem die Mikrowellenleistung so eingestellt wird, daß die Lampe durch das Plasma vor Mikrowellenstrahlung geschützt wird, so daß keine Erwärmung der Metallteile und damit keine Beschädigung auftritt und ferner auch kein Plasma innerhalb der Lampe gezündet wird.

Es hat sich gezeigt, daß der Schwellenwert von vielen Parametern, wie Druck, Zusammensetzung des Beschichtungsgases, Bauart der Lampe, Anordnung der Lampe im Reaktor, Art des Reaktors, Vorhandensein einer Hilfsentladung als Zündhilfe, Einstellung von Anpassbauteilen für die Mikrowellen usw. abhängig ist, so daß der Schwellenwert experimentell ermittelt werden muß. Man kann diesen Schwellenwert beispielsweise dadurch ermitteln, daß man nacheinander unterschiedliche Mikrowellen-Leistungen vorgibt und diese für die typische Dauer einer Beschichtung eingestellt läßt und anschließend nach Ausschalten der Mikrowelle die Temperatur der Wendel der Lampe mißt. Hohe Temperaturen bedeuten, daß die Mikrowellen-Leistung unter dem Schwellenwert lag.

Wird die Lampe zu lange Mikrowellen-Leistungen unterhalb des Schwellenwertes unter der Mikrowellen-Leistung ausgesetzt, so wird beispielsweise ihre Wendel zu stark erhitzt.

Um deshalb eine Beschädigung der zu beschichtenden Lampe während des Einund Ausschaltens der über dem Schwellenwert liegenden Mikrowellenleistung zu verhindern, sollten die Flanken vorzugsweise eine Steigung ≥ 1/50 kW/ms aufweisen.

Vorzugseise wird eine Anordnung gewählt, bei der das Plasma als Innenleiter eines koaxialen Mikrowellenleiters angesehen werden kann und sich die zu beschichtende Lampe innerhalb des Bereichs des Innenleiters befindet.

Mit dem Verfahren lassen sich Lampen mit einer Einzelschicht oder mit mehreren Schichten, z.B. einem Vielschichtinterferenzsystem belegen. Das Interferenzsystem ist vorzugsweise ein System, das die IR-Strahlung der Leuchtwendel auf diese reflektiert. Die zu beschichtenden Lampen sind vorzugsweise Halogenlampen mit typischerweise kugelförmigen, zylindrischen, rohrförmigen oder ellipsoidähnlichen Lampenkolben, in dessen Zentrum sich die Leuchtwendel befindet und deren Stromversorgung über zwei Kontaktstifte in einem oder zwei Quetschfüßen erfolgt.

Vorzugsweise wird das Beschichtungsgas in Ausbreitungsrichtung oder entgegen der Ausbreitungsrichtung der Mikrowellen in die Reaktionskammer eingeleitet und/oder abgeführt. Man erhält dadurch in der Reaktionskammer eine symmetrische Gasverteilung.

Unter dieser Voraussetzung wird ferner vorzugsweise die Symmetrieachse der Lampen parallel zur Strömungsrichtung des in den Mikrowellenreaktor eingeleiteten Beschichtungsgases ausgerichtet. Dadurch wird innerhalb der Reaktionskammer ein symmetrisches Plasma erzeugt. das dann auch eine symmetrische Abschirmung der Lampe von den Mikrowellen gewährleistet.

Wird ein konstant brennendes Mikrowellenplasma zur Schichtbildung angewendet, fällt die Beschichtungsrate im allgemeinen in der Flußrichtung der Beschichtungsgasese ab und die auf der Lampe entstehende Schicht hat einen entsprechenden Verlauf in der Schichtdicke, sofern ihre Achse und die Richtung der Mikrowellenausbreitung in Flußrichtung angeordnet sind. Ein solcher Verlauf ist zur Herstellung von mehrfarbig leuchtenden Lampen geeignet. Um die Beschichtung zunehmend farblos. d.h. uniformer zu machen. werden die Mikrowellen vorzugsweise entgegen der Strömungsrichtung des eingeleiteten Beschichtungsgases eingestrahlt. Ferner kann man stattdessen oder zusätzlich die Mikrowellenleistung vermindern und/oder den Massenfluß des Beschichtungsgases erhöhen.

Vorzugsweise wird ein PICVD-Verfahren verwendet, mit dem die Mikrowelle gepulst in den Reaktor eingestrahlt wird. Mikrowellen-PICVD-Verfahren haben folgende Vorteile:
- vergleichsweise hoher Prozeßdruck und damit Vermeidung anspruchsvoller Vakuumtechnik
- hohe Beschichtungsrate
- hohe Brechzahlen und gute Schichtstöchiometrie
- Möglichkeit der Einzelplatzbeschichtung, daher eine problemlose Skalierbarkeit.

Mit dem PICVD-Verfahren (Plasma-lmpuls-CVD-Verfahren) können insbesondere sehr uniforme Schichten hergestellt werden. Ein nach dem PICVD-Verfahren auf die Außenfläche von Glühlampen aufgebrachte IRreflektierende Beschichtung aus beispielsweise TiO₂- und SiO₂-Schichten zeichnen sich neben einer hohen Uniformität durch eine sehr gute Temperaturbeständigkeit der mechanischen und optischen Eigenschaften aus, wobei eine hohe Brechzahl für die hochbrechenden TiO₂-Schichten erreicht wird, so daß das Schichtsystem mit vergleichsweise wenigen Schichten - und somit sehr wirtschaftlich - aufgebaut werden kann. Die Anforderungen an ein IR-reflektierenden Vielschichtsystem auf Halogenlampen lassen sich somit auf einfache Weise erfüllen.

Vorzugsweise werden Mikrowellenimpulse mit steilen Flanken, insbesondere Rechteckimpulse, verwendet. Die Flanken sämtlicher Impulse sollten eine Steigung ≥ 1/50 kW/ms aufweisen. Dies ist insofern wichtig, als die Zeit, in der die Lampe der Mikrowellenstrahlung ohne Anwesenheit eines Plasmas ausgesetzt ist, möglichst kurz sein soll.

Ferner sollte die Impulspause zwischen zwei Mikrowellenimpulsen mindestens unverbrauchtes Beschichtungsgas ausgetauscht werden kann. Dadurch wird eine sehr gute Uniformität der Beschichtung erreicht. Beträgt der Massenfluß des Beschichtungsgases MF (mbar x 1/s), der Druck im Reaktor p (mbar) und das Reaktorvolumen V (1), dann kann die Zeit t zwischen zwei aufeinanderfolgenden Mikrowellenimpulsen annährungsweise mit t ≥ Vxp/MF berechnet werden.

Die Dauer ID der Mikrowellenimpulse sollte zwischen 0,1 und 10 ms. vorzugsweise zwischen 0,3 und 2 ms, und der Druck p im Reaktor zwischen 0.1 und 10 mbar, vorzugsweise zwischen 0,2 und 1,5 mbar gewählt werden. Die Grenzen von ID und p ergeben sich aus folgenden Randbedingungen:
- ID:: Der Schichtbildungsprozeß erfordert Mindestzeiten in der Größenordnung von 0,1 ms.
- p:: Drücke wesentlich kleiner als 0,1 mbar erfordern leistungsfähigere und damit teurerer Pumpen und machen den Prozeß somit unwirtschaftlich. Die Qualität von Beschichtungen, die bei Drücken von etwas größer 10 mbar hergestellt werden, ist wegen der mit zunehmendem Druck stärker werdenden Homogenreaktion (Partikelbildung) gering,

Der Massenfluß des Beschichtungsgases pro Querschnittsfläche des Reaktors bewegt sich vorzugsweise in den Grenzen 0,015 bis 1,5 mbar x 1/s/cm². Unterhalb der unteren Grenze dauert die Beschichtung zu lange und wird daher unwirtschaftlich. Bei Überschreiten der oberen Grenze verschlechtert sich die Schichtqualität.

Obwohl die Flächenelemente der Lampe unterschiedlichen Abstand zu den Flächenelementen der Begrenzung des Reaktorraums haben und die eingeschlossenen Gasvolumina, aus denen die Bestandteile der Schicht herrühren, unterschiedlich groß sind, lassen sich überraschend gute Uniformitäten erzielen, ohne daß Reaktorbauteile auf die Abmessungen der Lampe abgestimmt sind. Dies ist deshalb von Bedeutung, weil so mit der gleichen Anordnung verschieden gestaltete Lampen beschichtet werden können.

Offenbar reicht es zur Erzielung einer ausreichend hohen Uniformität aus, den zu beschichtenden Bereich der Lampe in einem genügend großen Abstand zur Reaktorwand anzuordnen. Es wurde gefunden, daß dieser Mindestabstand Dₘᵢₙ druckabhängig ist. Er beträgt etwa 3 mm bei einem Mindestdruck Pₘᵢₙ von 0.35mbar. Seine Druckabhängigkeit folgt in etwa dem Gesetz: Dₘᵢₙ x Pₘᵢₙ = 1 mm x mbar.

Vorzugsweise ist daher der Druck Pₘᵢₙ in mbar im Inneren des Mikrowellenreaktors gleich Pₘᵢₙ ≈ 1/Dₘᵢₙ, wobei Dₘᵢₙ der Mindestabstand der Lampe von der Wand des Mikrowellenreaktors in mm ist.

Die erfindungsgemäße Vorrichtung ist dadurch gekennzeichnet, daß die Reaktionskammer ein Mikrowellenreaktor ist, der Mittel aufweist, mit denen die Lampe mit ihrer Symmetrieachse parallel zur Strömungsrichtung des Beschichtungsgases ausrichtbar ist, daß mindestens eine der Begrenzungswände des Mikrowellenreaktors eine Lochplatte zum Zuführen und/oder Abführen des Beschichtungsgases aufweist, und daß der Mikrowellengenerator zum Einstellen einer vorgesehenen Mikrowellenleistung und zum Einstellen einer vorgegebenen Steigung der Ein- und Ausschaltflanke der Mikrowellenleistung ausgebildet ist.

Die Lochplatte befindet sich vorzugsweise oberhalb oder unterhalb der zu beschichtenden Lampe, die senkrecht zur Lochplatte ausgerichtet ist. Bezüglich des Mikrowellenleiters oder einer Mikrowellenantenne ist die Lochplatte vorzugsweise senkrecht angeordnet. Vorzugsweise weisen zwei gegenüberliegende Begrenzungswände jeweils eine Lochplatte auf, so daß durch die eine Lochplatte das Beschichtungsgas zugeführt und durch die andere Lochplatte das verbrauchte Beschichtungsgas abgeführt werden kann. Auch bei dieser Anordnung ist die zu beschichtende Lampe senkrecht zu den beiden Lochplatten angeordnet. Beide Lochplatten sind vorzugsweise parallel zueinander ausgerichtet.

Die Lampe kann in einer der Lochplatten gehalten werden, wozu diese Lochplatte entsprechende Mittel zur Aufnahme der Lampe aufweist.

Beispielhafte Ausführungsformen der Erfindung werden nachfolgend anhand der Zeichnungen näher erläutert.

Es zeigen:
- Figur 1: einen Vertikalschnitt durch eine Vorrichtung zur Außenbeschichtung mit zwei Lochplatten.
- Figur 2: eine Vorrichtung im Vertikalschnitt gemäß einer weiteren Ausführungsform mit einer Lochplatte,
- Figuren 3 und 4: einen Vertikalschnitt durch eine Vorrichtung gemäß weiterer Ausführungsformen mit einer Plasmainnenleiteranordnung und
- Figur 5: eine Vorrichtung mit einer Lochplatte gemäß einer weiteren Ausführungsform.

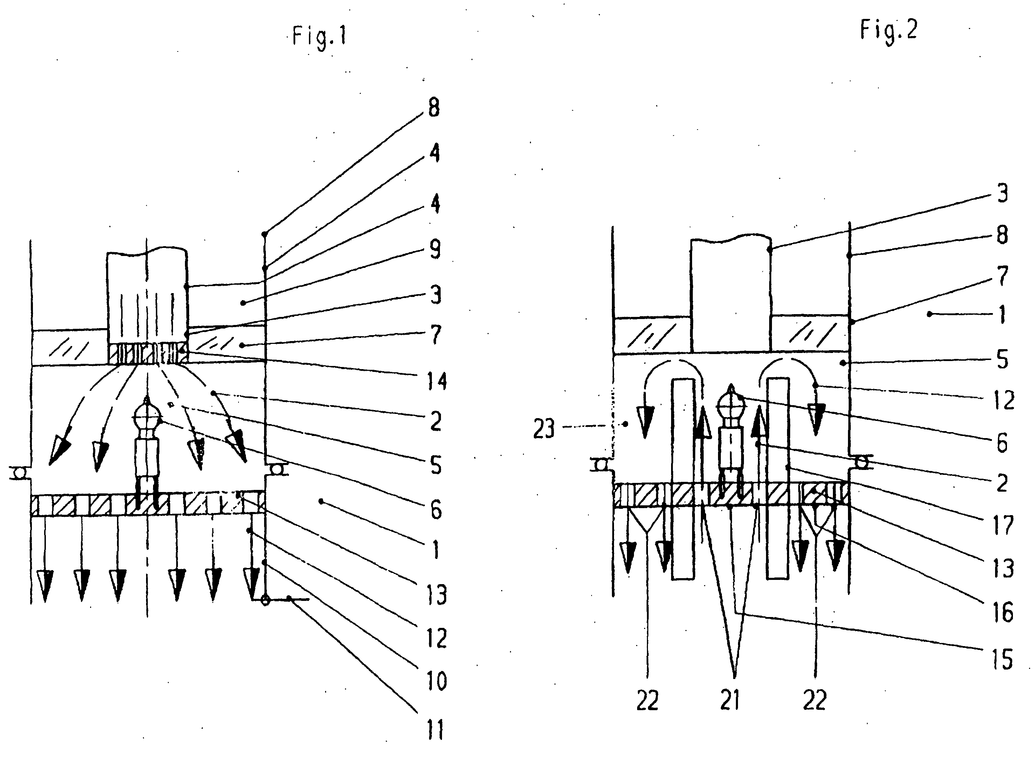

In der Figur 1 ist ein Mikrowellenreaktor 1 im Vertikalschnitt schematisch dargestellt. Die Mikrowellen werden von oben durch den aus Innenleiter 3 und Außenleiter 8 gebildeten Koaxialleiter 4 zugeführt, wobei der Innenleiter durch eine Lochplatte 14 abgeschlossen ist und zwischen dem Innenleiter und dem Außenleiter eine dielektrische Dichtung 7 angeordnet ist. Unterhalb der Lochplatte 14 und der Dichtung 7 befindet sich die Reaktionskammer 5, in der mittig die zu beschichtende Lampe 6 auf einer zweiten Lochplatte 13 angeordnet ist. Beide Lochplatten 13, 14 sind senkrecht zum Koaxialleiter 4 ausgerichtet.

Das Beschichtungsgas 2 wird durch den Innenleiter 3 der koaxialen Mikrowellenleitung 4 durch die Lochplatte 14 in die Reaktionskammer 5 eingeleitet. Die Lochplatte ist derart ausgestattet, daß ein gleichmäßiger Auslaß von Beschichtungsgas gewährleistet ist. Dadurch, daß die Lampe mittig innerhalb der Reaktionskammer 5 angeordnet ist und beide Lochplatten 13 und 14 symmetrisch angeordnet sind, wird gewährleistet, daß die zu beschichtende Lampe mit dem Beschichtungsgas gleichmäßig umströmt wird, wobei die Symmetrieachse der Lampe parallel zur Strömungsrichtung des Beschichtungsgases ausgerichtet ist. In der Reaktionskammer 5 wird das Beschichtungsgas in den Plasmazustand gebracht und zur Schichtbildung angeregt. Durch die dielektrische Dichtung 7 und durch die Füllung des Raumes 9 zwischen Innenleiter 3 und Außenleiter 8 mit einem beispielsweise unter Atmosphärendruck stehenden Gas wird dafür gesorgt, daß im Raum 9 kein Plasma gezündet wird. Eine isoliert durch die Wand 10 durchgeführte Zündelektrode 11, die an eine nicht dargestellt Hochspannungsversorgung angeschlossen ist, dient dazu. das Plasma in der Reaktionskammer 5 sicher zu zünden. Das Abgas 12 wird durch die untere Lochplatte 13 mittels einer nicht dargestellten Vakuumpumpe abgesaugt.

Die Mikrowellenleistung wird so eingestellt, daß der Schwellenwert für die gesamte Anordnung überschritten wird und das Plasma mindestens eine Elektronendichte von > 10¹⁰ 1/cm³ aufweist. Die Beschichtung kann mit folgenden Parametern gemäß den Beispielen 1 und 2 durchgeführt werden.

### Beispiel 1:

Unter einer Gasdusche mit einstellbaren Öffnungen ist eine Halogenlampe (aus Quarzglas) stehend in einem Sockel elektrisch leitend gehalten, der wiederum in einer Basisplatte steckt. Das Beschichtungsgas strömt koaxial zur Symmetrieachse der Lampe.
Mit folgenden Prozeßparametern wurde ein klares, hocheffizientes und haltbares infrarotreflektierendes Schichtpaket hergestellt:

| | |
|---|---|
| Druck | 0,35 mbar |
| Massenfluß des Beschichtungsgases (O₂ + TiCl₄ bzw. HMDSO) | 3,4 mbar x 1/s |
| Impulsdauer | 0,6ms |
| Impulspause | 22ms |
| MW-Impulsleistung | 2,7 kW |

### Beispiel 2:

In einem anderen Ausführungsbeispiel ist die die zu beschichtende Lampe (aus Hartglas) auf den MW-Innenleiter aufgesteckt, so daß sich die Lampe im Bereich der höchsten Feldstärke befindet.
In diesem Fall wurden mit folgenden Parametern entsprechend gute Ergebnisse erzielt:

| | |
|---|---|
| Druck | 0,6mbar |
| Massenfluß des Beschichtungsgases (O₂ + TiCl₄ bzw. HMDSO) | 5,9 mbar x 1/s |
| MW-Leistung | 2,7 kW |

In der Figur 2 ist eine Vorrichtung dargestellt, bei der das Beschichtungsgas nicht von oben sondern durch die untere Lochplatte 13 zugeführt wird. Die Lampe 6 ist auf dieser unteren Lochplatte 13 befestigt und von Öffnungen 21 im Bereich 15 umgeben, durch die das Beschichtungsgas einströmt. Auch bei dieser Anordnung ist die Symmetrieachse der Lampe 6 parallel zur Strömungsrichtung des Beschichtungsgases 2 ausgerichtet. Im Bereich der dielektrischen Dichtung 7 wird das Beschichtungsgas bzw. das verbrauchte Beschichtungsgas umgelenkt, wobei ein Zylinder 17 innerhalb der Reaktionskammer 5 frisches Beschichtungsgas und verbrauchtes Beschichtungsgas voneinander trennt. Das verbrauchte Beschichtungsgas wird durch den den Zylinder 17 umgebenden Ringraum 23 ebenfalls durch die untere Lochplatte 13 abgesaugt. Hierzu sind im äußeren Bereich 16 Öffnungen 22 vorgesehen.

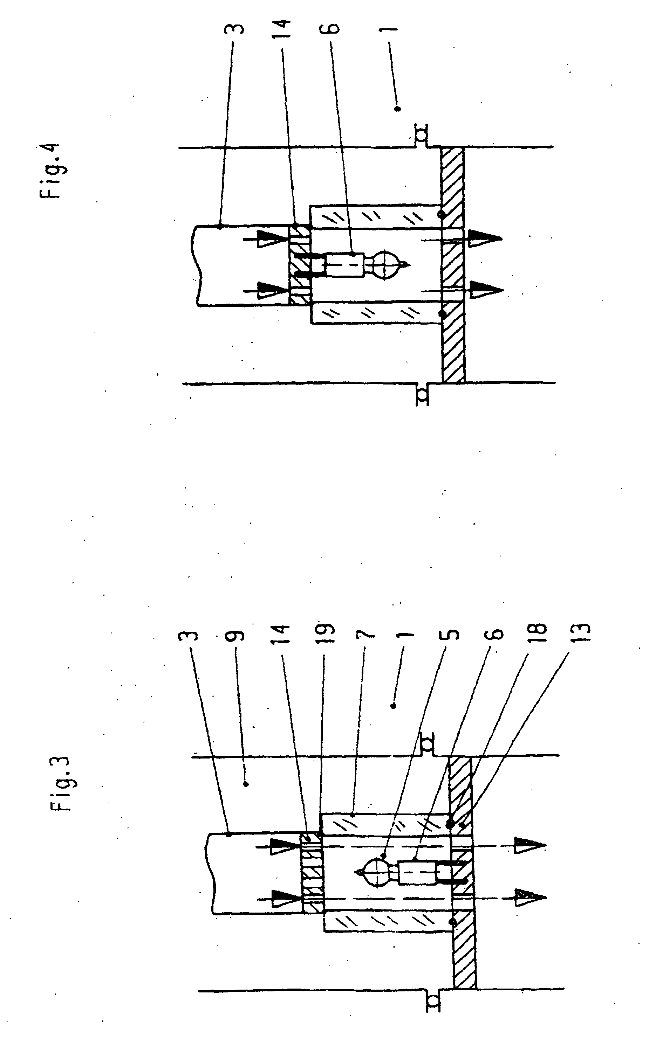

In der Figur 3 ist die dielektrische Dichtung 7 nicht horizontal angeordnet sondern vertikal und umschließt die Reaktionskammer 5. Die dielektrische Dichtung 7, die den Raum 9 vom Reaktionsraum 5 trennt, besteht aus einem leicht auswechselbaren Zylinder, der über die Dichtelemente 18 und 19 an der unteren Lochplatte 13 und den Innenleiter 3 gepreßt wird. Das bei der Reaktion brennende Plasma kann als Fortsetzung des Innenleiters 3 angesehen werden, so daß die Vorrichtung bis zur unteren Lochplatte 13 entsprechend als koaxialer Mikrowellenleiter angesehen werden kann. Die Lampe 6 wird somit wirksam von den Mikrowellen abgeschirmt.

In einer Vorrichtung entsprechend der Figur 3 wurde eine Lampe 6 aus Hartglas mit folgender Konfiguration beschichtet:

| | |
|---|---|
| Außendurchmesser des Innenleiters | 50mm |
| Innendurchmesser des Außenleiters | 80mm |
| Abstand Lampe-Reaktorwand | 12,5mm |
| Anordnung der Lampe im Reaktorraum | mittig |
| Verbindung zwischen Lampe und Grundplatte | leitend |
| Prozeßdruck | 0,35mbar |
| Pulsdauer | 0,6ms |
| Pulspause | 26ms |
| Massenfluß des Beschichtungsgases (O2 + TiCl ₄ ) | 5 mbar x 1/s. |

Um eine sichere Zündung zu gewährleisten, wurde während der Beschichtung mittels einer unter der Grundplatte angebrachten Zündelektrode, an der eine Spannung (50kHz) von 3kV lag, eine Hilfsentladung brennen gelassen. Nur wenn eine Mikrowellen-Impuls-Leistung > 1,8 kW (die maximale Pulsleistung betrug 3000 W) eingestrahlt wird, wird die Lampe nicht zerstört und ist eine einwandfreie Beschichtung möglich. Der Schwellenwert beträgt somit 1.8 kW.

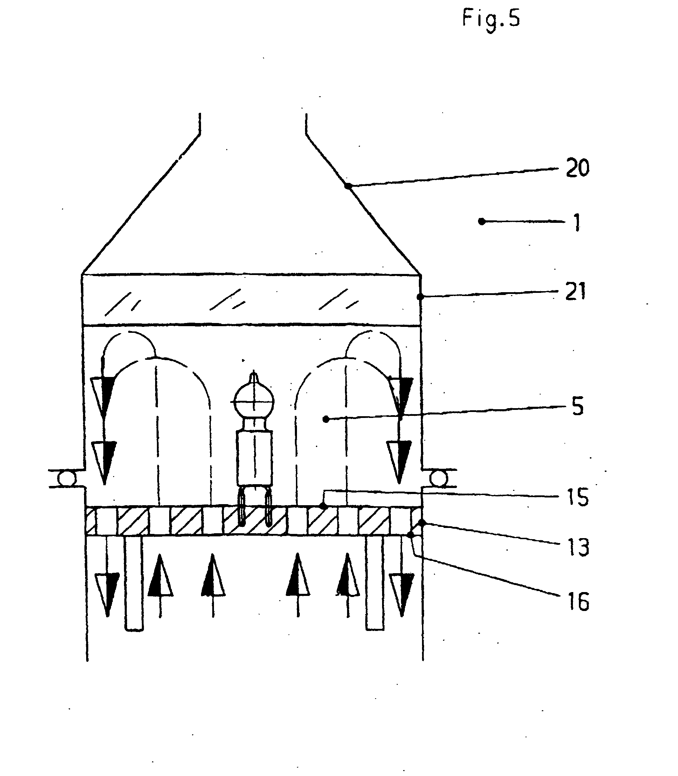

Die Anordnung der Figuren 4 und 5 unterscheidet sich von derjenigen in der Figur 3 lediglich dadurch, daß die Lampe 6 nicht in der unteren Lochplatte 13 sondern in der oberen Lochplatte 14 angeordnet ist, die die Abschlußplatte für den Innenleiter 3 bildet.

In der Figur 5 wird die Mikrowellenenergie durch eine Antenne 20, z.B. einen Hornstrahler durch ein dielektrisches Fenster 21 in den Reaktionsraum 5 eingestrahlt. Wie gemäß der Figur 2 wird das Beschichtungsgas von unten durch die untere Lochplatte 13 im Bereich 15 zugeführt und den Bereich 16 der Lochplatte abgesaugt.

Bei allen gezeigten Vorrichtungen wird die Lampe 6 vorzugsweise über die Stifte mit der Lochplatte oder dem Innenleiter 3 leitend verbunden, z.B. in vorgesehene Bohrungen gesteckt. Bei allen gezeigten Vorrichtungen kann die Gasflußrichtung umgedreht werden, d.h. der Gaseingang zum Gasausgang gemacht werden und umgekehrt.

## Patentansprüche

1. Verfahren zur Außenbeschichtung von Lampen, **dadurch gekennzeichnet,**
**daß** die Beschichtung in einem Mikrowellenreaktor mittels eines Mikrowellenplasma-CVD-Verfahrens durchgeführt wird.

2. Verfahren nach Anspruch 1, **dadurch gekennzeichnet, daß** die in den Mikrowellenreaktor eingekoppelte Mikrowellenleistung ≥ einem Schwellenwert gewählt wird, bei dem sich ein Plasma mit verminderter Durchlässigkeit für Mikrowellen-Strahlung einstellt.

3. Verfahren nach Anspruch 1, **dadurch gekennzeichnet, daß** die Mikrowellenleistung mit ≥ 1/50 kW/ms ein- und ausgeschaltet wird.

4. Verfahren nach einem der Ansprüche 1 bis 3, **dadurch gekennzeichnet. daß** die Lampe im Mikrowellenreaktor innerhalb des Bereichs eines Innenleiters eines koaxialen Mikrowellenleiters angeordnet ist.

5. Verfahren nach einem der Ansprüche 1 bis 4, **dadurch gekennzeichnet, daß** das Beschichtungsgas in Ausbreitungsrichtung oder entgegen der Ausbreitungsrichtung der Mikrowellen in die Reaktionskammer eingeleitet und/oder abgeführt wird.

6. Verfahren nach einem der Ansprüche 1 bis 5, **dadurch gekennzeichnet. daß** die Symmetrieachse der Lampe parallel zur Strömungsrichtung des in den Mikrowellenreaktor eingeleiteten Beschichtungsgases ausgerichtet wird.

7. Verfahren nach einem der Ansprüche 1 bis 6, **dadurch gekennzeichnet, daß** die Mikrowellen entgegen der Strömungsrichtung des eingeleiteten Beschichtungsgases eingestrahlt werden.

8. Verfahren nach einem der Ansprüche 1 bis 7, **dadurch gekennzeichnet. daß** ein PICVD-Verfahren verwendet wird.

9. Verfahren nach Anspruch 8, **dadurch gekennzeichnet, daß** Mikrowellenimpulse mit steilen Flanken, insbesondere Rechteckimpulse, verwendet werden.

10. Verfahren nach einem der Ansprüche 8 oder 9, **dadurch gekennzeichnet, daß** die Impulspause zwischen zwei Mikrowellenimpulsen so groß gewählt wird, daß der Gasinhalt des Reaktionsvolumens gegen unverbrauchtes Beschichtungsgas ausgetauscht werden kann.

11. Verfahren nach einem der Ansprüche 1 his 10, **dadurch gekennzeichnet, daß** der Druck Pₘᵢₙ in mbar im Inneren des Mikrowellenreaktors gleich Pₘᵢₙ ≈ 1/Dₘᵢₙ gewählt wird, wobei Dₘᵢₙ der Mindestabstand der Lampe von der Wand des Mikrowellenreaktors in mm ist.

12. Vorrichtung zur Außenbeschichtung von Lampen, mit einer Reaktionskammer, in der die Lampe angeordnet ist, und mit Einrichtungen zum Zu- und Abführen von Beschichtungsgas. **dadurch gekennzeichnet, ,**
**daß** die Reaktionskammer (5) ein Mikrowellenreaktor (1) ist, der Mittel aufweist, mit denen die Lampe (6) mit ihrer Symmetrieachse parallel zur Strömungsrichtung des Beschichtungsgases ausrichtbar ist, daß mindestens eine der Begrenzungswände des Mikrowellenreaktors (1) eine Lochplatte (13, 14) zum Zuführen und/oder Abführen des Beschichtungsgases aufweist, und
**daß** der Mikrowellengenerator zum Einstellen einer vorgesehenen Mikrowellenleistung und zum Einstellen einer vorgegebenen Steigung der Ein- und Ausschaltflanke der Mikrowellenleistung ausgebildet ist.

13. Vorrichtung nach Anspruch 12, **dadurch gekennzeichnet, daß** zwei gegenüberliegende Begrenzungswände jeweils eine Lochplatte (13,14) aufweisen.

14. Vorrichtung nach einem der Ansprüche 12 oder 13, **dadurch gekennzeichnet, daß** eine der Lochplatten (13, 14) Mittel zur Aufnahme der Lampe aufweist.

15. Vorrichtung nach einem der Ansprüche 12 bis 14. **dadurch gekennzeichnet, daß** die Lochplatte (13,14) senkrecht zum an den Mikrowellenreaktor (1) angeschlossenen Mikrowellenleiter (4) oder Mikrowellenantenne (20) angeordnet ist.

## Claims

1. Process for externally coating lamps, **characterized**
**in that** the coating is carried out in a microwave reactor by means of a microwave plasma CVD process.

2. Process according to Claim 1, **characterized in that** the microwave power coupled into the microwave reactor is chosen to be ≥ threshold value at which a plasma with reduced transmissivity for microwave radiation is established.

3. Process according to Claim 1, **characterized in that** the microwave power is switched on and off at ≥ 1/50 kW/ms.

4. Process according to one of Claims 1 to 3, **characterized in that** the lamp is arranged in the microwave reactor within the region of an internal conductor of a coaxial microwaveguide.

5. Process according to one of Claims 1 to 4, **characterized in that** the coating gas is introduced into the reaction chamber and/or conducted away in the direction of propagation or counter to the direction of propagation of the microwaves.

6. Process according to one of Claims 1 to 5, **characterized in that** the axis of symmetry of the lamp is oriented parallel to the flow direction of the coating gas introduced into the microwave reactor.

7. Process according to one of Claims 1 to 6, **characterized in that** the microwaves are radiated in counter to the flow direction of the introduced coating gas.

8. Process according to one of Claims 1 to 7, **characterized in that** a PICVD process is used.

9. Process according to Claim 8, **characterized in that** microwave pulses with steep edges, in particular square-wave pulses are used.

10. Process according to either of Claims 8 and 9, **characterized in that** the pulse interval between two microwave pulses is chosen to be large enough that the gas content of the reaction volume can be exchanged for unspent coating gas.

11. Process according to one of Claims 1 to 10, **characterized in that** the pressure Pₘᵢₙ in mbar in the interior of the microwave reactor is chosen to be equal to Pₘᵢₙ ≈ 1/Dₘᵢₙ, where Dₘᵢₙ is the minimum distance between the lamp and the wall of the microwave reactor in mm.

12. Apparatus for externally coating lamps, having a reaction chamber, in which the lamp is arranged, and having devices for leading in and conducting away coating gas, **characterized**
**in that** the reaction chamber (5) is a microwave reactor (1), which has means which enable the lamp (6) to be oriented with its axis of symmetry parallel to the flow direction of the coating gas,
**in that** at least one of the boundary walls of the microwave reactor (1) has a perforated plate (13, 14) for feeding and/or conducting away the coating gas, and
**in that** the microwave generator is designed for setting an envisaged microwave power and for setting a predetermined slope of the switch-on and -off edge of the microwave power.

13. Apparatus according to Claim 12, **characterized in that** two opposite boundary walls each have a perforated plate (13, 14).

14. Apparatus according to either of Claims 12 and 13, **characterized in that** one of the perforated plates (13, 14) has means for receiving the lamp.

15. Apparatus according to one of Claims 12 to 14, **characterized in that** the perforated plate (13, 14) is arranged perpendicularly to the microwave conductor (4) or microwave antenna (20) connected to the microwave reactor (1).

## Revendications

1. Procédé pour le revêtement extérieur de lampes, **caractérisé en ce que** le revêtement est réalisé dans un réacteur à micro-ondes au moyen d'un procédé de CVD à plasma sous micro-ondes.

2. Procédé selon la revendication 1, **caractérisé en ce que** la puissance des micro-ondes couplée à l'intérieur du réacteur à micro-ondes est sélectionnée de manière à être ≥ à une valeur de seuil pour laquelle s'établit un plasma qui présente une perméabilité réduite vis-à-vis du rayonnement de micro-ondes.

3. Procédé selon la revendication 1, **caractérisé en ce que** la puissance des micro-ondes est branchée et débranchée à ≥ 1/50 kW/ms.

4. Procédé selon l'une quelconque des revendications 1 à 3, **caractérisé en ce que** la lampe est disposée dans le réacteur à micro-ondes à l'intérieur de la zone d'un conducteur intérieur d'un conducteur coaxial de micro-ondes.

5. Procédé selon l'une quelconque des revendications 1 à 4, **caractérisé en ce que** le gaz de revêtement est introduit et/ou évacué de la chambre de réaction dans la direction de propagation ou en opposition à la direction de propagation des micro-ondes.

6. Procédé selon l'une quelconque des revendications 1 à 5, **caractérisé en ce que** l'axe de symétrie de la lampe est orienté parallèlement à la direction d'écoulement du gaz de revêtement introduit dans le réacteur à micro-ondes.

7. Procédé selon l'une quelconque des revendications 1 à 6, **caractérisé en ce que** les micro-ondes sont émises en opposition à la direction d'écoulement du gaz de revêtement introduit.

8. Procédé selon l'une quelconque des revendications 1 à 7, **caractérisé en ce que** l'on utilise un procédé PICVD.

9. Procédé selon la revendication 8, **caractérisé en ce que** l'on utilise des impulsions de micro-ondes à flancs raides, en particulier des impulsions rectangulaires.

10. Procédé selon l'une des revendications 8 ou 9, **caractérisé en ce que** l'intervalle entre impulsions entre deux impulsions de micro-ondes est sélectionné de telle sorte que le gaz contenu dans le volume de réaction puisse être remplacé par du gaz de revêtement non épuisé.

11. Procédé selon l'une quelconque des revendications 1 à 10, **caractérisé en ce que** la pression Pₘᵢₙ en mbar à l'intérieur du réacteur à micro-ondes est égale à Pₘᵢₙ ≈ 1/Dₘᵢₙ, Dₘᵢₙ étant la distance minimale entre la lampe et la paroi du réacteur à micro-ondes, en mm.

12. Dispositif pour le revêtement extérieur de lampes, comprenant une chambre de réaction dans laquelle la lampe est disposée et des dispositifs pour l'apport et l'évacuation d'un gaz de revêtement,
**caractérisé en ce que** la chambre de réaction (5) est un réacteur à micro-ondes (1) qui présente des moyens par lesquels l'axe de symétrie de la lampe (6) peut être orienté parallèlement à la direction d'écoulement du gaz de revêtement,
**en ce qu'**au moins l'une des parois délimitant le réacteur à micro-ondes (1) présente une plaque perforée (13, 14) pour l'apport et/ou l'évacuation du gaz de revêtement, et
**en ce que** le générateur de micro-ondes est configuré pour établir une puissance prévue de micro-ondes et pour établir une pente prédéterminée du flanc de branchement et de débranchement de la puissance des micro-ondes.

13. Dispositif selon la revendication 12, **caractérisé en ce que** deux parois-limites opposées présentent chacune une plaque perforée (13, 14).

14. Dispositif selon l'une quelconque des revendications 12 ou 13, **caractérisé en ce que** l'une des plaques perforées (13, 14) présente des moyens pour recevoir la lampe.

15. Dispositif selon l'une quelconque des revendications 12 à 14, **caractérisé en ce que** la plaque perforée (13, 14) est disposée perpendiculairement au conducteur de micro-ondes (4) ou à l'antenne à micro-ondes (20) qui est raccordé(e) au réacteur à micro-ondes (1).
